# EUROPEAN PATENT APPLICATION

(11) **EP 4 561 272 A1**
(43) Date of publication of application: **28.05.2025**
(21) Application number: 24208197.4
(22) Date of filing: 22.10.2024
(51) Int. Cl.: H05K 1/05, H05K 1/18, H05K 3/00, H05K 1/02, H05K 1/14, H05K 3/44

(54) **METHOD FOR DISPOSING ELECTRONIC ELEMENT ON CABLE AND CABLE FOR DISPOSING ELECTRONIC ELEMENT**

(30) Priority: 24.11.2023 KR 20230165669
(71) Applicant: Hamburg (Jiangsu) Co., Ltd., Huaian Jiangsu (CN)
(72) Inventor: HUANG, Ya-Li, New Taipei City (TW)
(74) Representative: Cabinet Chaillot

(57) **Abstract**

A method for disposing an electronic element on a cable comprises the following steps: providing a cable having a first circuit and an insulating layer; cutting the first circuit and the insulating layer to form a first hole; removing a part of the insulating layer encapsulating the first circuit at the first hole to form a first opening and a second opening to expose a first segment of the first circuit and a second segment of the first circuit; and disposing a first electronic element in the first hole; wherein the first electronic element has a first pin and a second pin, the first pin is electrically connected to the first segment exposed by the first opening and the second pin is electrically connected to the second segment exposed by the second opening.

## Description

### 1. Field of the Invention

The invention relates to a method and a cable for disposing an electronic element, particularly to the method for disposing the electronic element on the cable and the cable thereof.

### 2. Description of the Prior Arts

Nowadays, a circuit board comprises various electronic elements. These electronic elements, including resistors, capacitors, and transistors, are disposed on the circuit board by different technologies such as the surface mount technique (SMT). Regardless of the technologies, each electronic element needs to be disposed on the circuit board according to a layout of the circuit board.

Limited by a finite area of the surface of the circuit board, excess electronic elements fail to be disposed on the surface of the circuit board. Therefore, a performance of the circuit board is limited.

Accordingly, how to provide a method for disposing an electronic element on a cable and the cable disposing an electronic element to solve the aforementioned problem is an urgent subject to tackle.

To overcome the shortcomings, the present invention provides a method for disposing an electronic element on a cable and the cable thereof to overcome the aforementioned problem.

The method for disposing an electronic element on a cable comprises the following steps:
providing a cable; wherein the cable has a first circuit and an insulating layer, and the insulating layer encapsulates the first circuit;
cutting the first circuit and the insulating layer in the cable to form a first hole; wherein a first segment and a second segment are formed by cutting the first circuit;
removing a part of the insulating layer encapsulating the first circuit at the first hole to form a first opening and a second opening; wherein a part of the first opening exposes the first segment of the first circuit and a part of the second opening exposes the second segment of the first circuit; and
disposing a first electronic element in the first hole; wherein the first electronic element has a first pin and a second pin, the first pin is electrically connected to the first segment exposed by the first opening and the second pin is electrically connected to the second segment exposed by the second opening.

Furthermore, the present invention further discloses another method for disposing an electronic element on a cable, and the method comprises the following steps:
providing a cable; wherein the cable has a first circuit, a second circuit, and an insulating layer; wherein the first circuit and the second circuit are disposed in parallel and encapsulated by the insulating layer;
removing the insulating layer encapsulating a part of the first circuit and a part of the second circuit at a predetermined position for disposing the electronic element to form a groove; wherein a part of the first circuit and a part of the second circuit are exposed by the groove; and
disposing a second electronic element in the groove; wherein the second electronic element has a third pin and a fourth pin, the third pin is electrically connected to the first circuit exposed by the groove, and the fourth pin is electrically connected to the second circuit exposed by the groove.

Moreover, the invention further discloses a cable for disposing an electronic element, and the cable comprises a first circuit, an insulating layer, a first hole, a first opening, and a second opening. The first circuit comprises a first segment and a second segment. The insulating layer encapsulates the first circuit. The first hole is disposed between the first segment and the second segment in the insulating layer. The first opening is disposed in the first hole and exposing a part of the first segment. The second opening is disposed in the first hole and exposing a part of the second segment. A first electronic element is disposed in the first hole. The first electronic element has a first pin and a second pin. The first pin is electrically connected to the first segment exposed by the first opening. The second pin is electrically connected to the second segment exposed by the second opening.

In addition, the invention further discloses a cable for disposing an electronic element, the cable comprising a first circuit, a second circuit, an insulating layer, and a groove. The second circuit is disposed in parallel with the first circuit. The insulating layer encapsulates the first circuit and the second circuit. The groove is disposed in the insulating layer and exposes a part of the first circuit and a part of the second circuit. A second electronic element is disposed in the groove. The second electronic element has a third pin and a fourth pin. The third pin is electrically connected to the first circuit exposed by the groove. The fourth pin is electrically connected to the second circuit exposed by the groove.

As mentioned above, since the cable is readily available, the electronic element can be disposed by the method for disposing the electronic element on the cable and the cable thereof in the present invention.

Other objectives, advantages and novel features of the invention will become more apparent from the following detailed description when taken in conjunction with the accompanying drawings.

### IN THE DRAWINGS

FIG. 1A to FIG. 1D show process flows of a first method for disposing the electronic element on the cable;
FIG. 2A to FIG. 2D are a top view corresponding to FIG. 1A to FIG. 1D;
FIG. 3 is a section view for disposing the electronic element on the first circuit;
FIG. 4A to FIG. 4C show process flows of the second embodiment for disposing the electronic element on the cable;
FIG. 5A and FIG. 5B are respectively a stereo diagram and an enlarged schematic diagram of the third embodiment for combining the first embodiment and the second embodiment; and
FIG. 6A to FIG. 6E illustrate process flows of folding the circuit of the cable circuit.

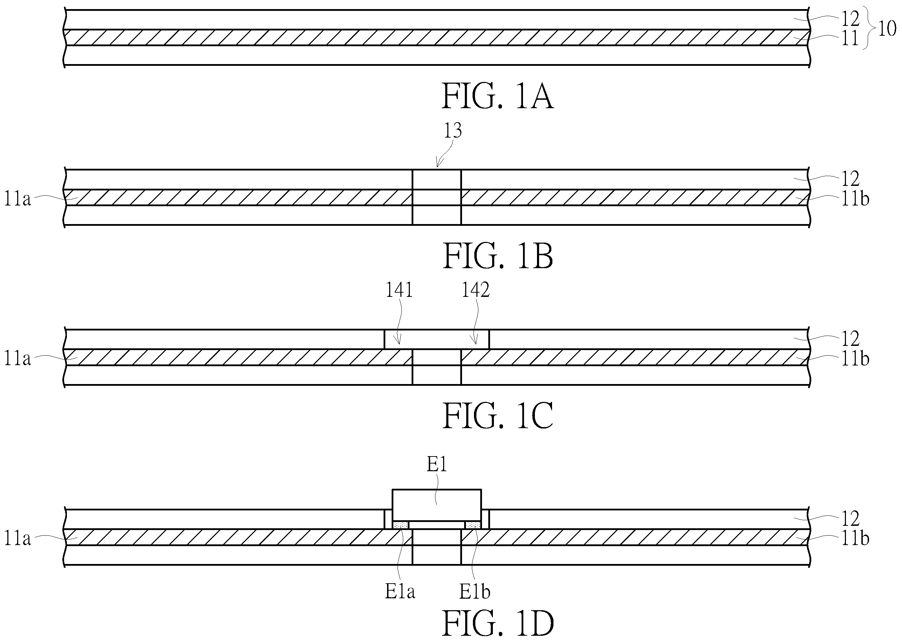

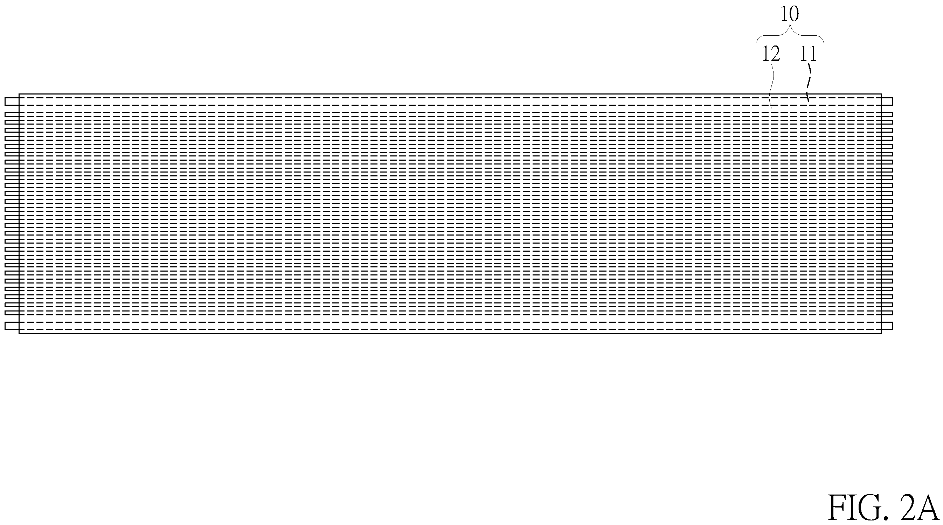

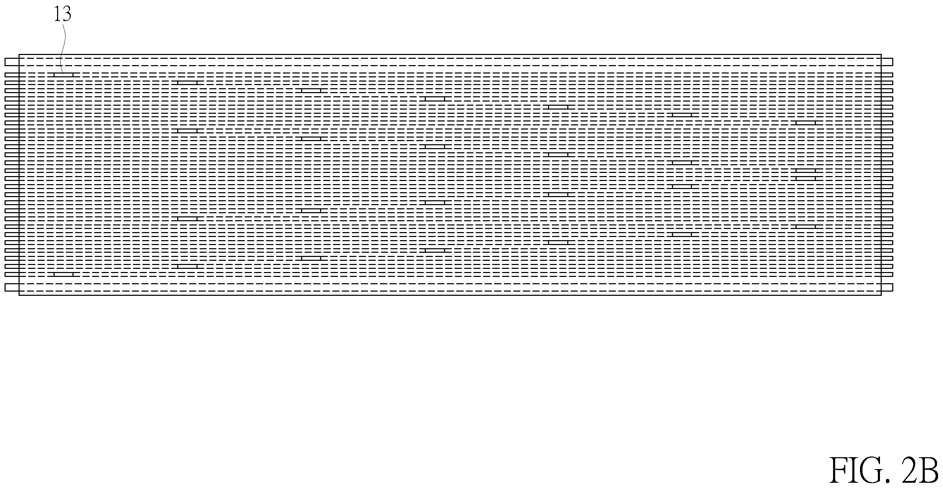

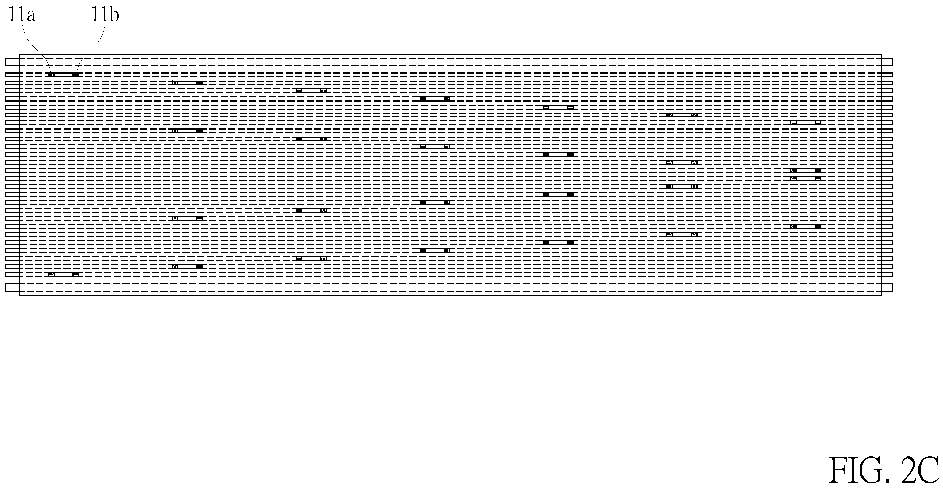

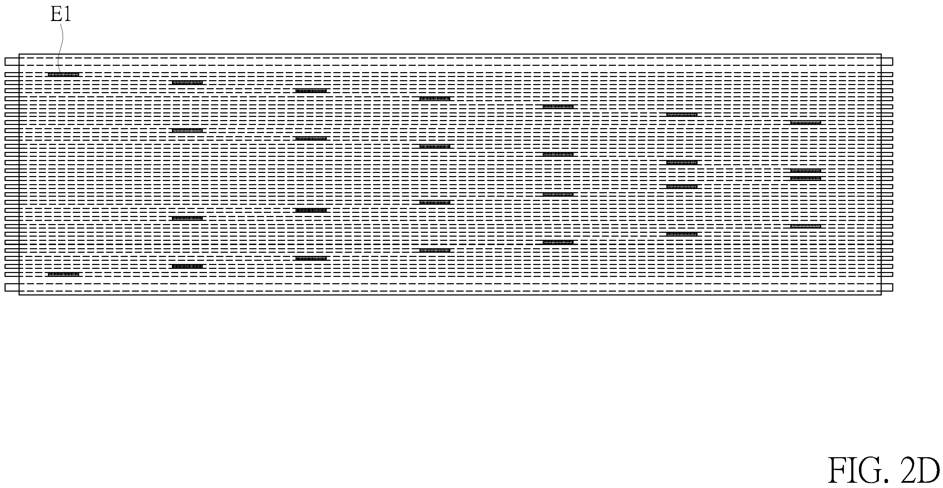

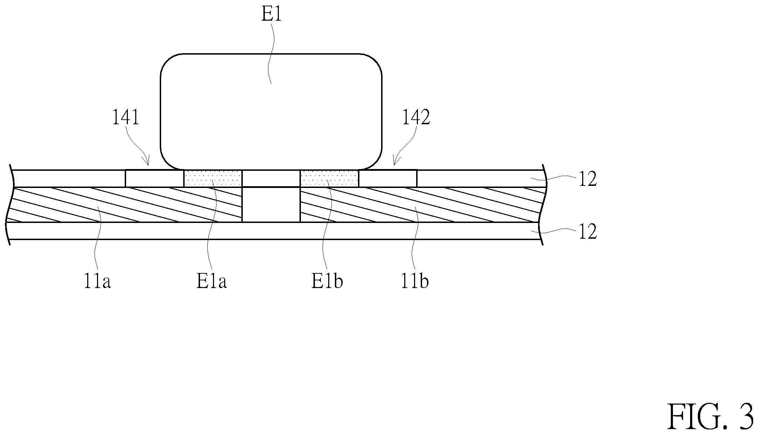

Referring to FIG. 1A to FIG. 1D, FIG. 2A to FIG. 2D, and FIG. 3, FIG. 1A to FIG. 1D show process flows of the first embodiment for disposing the electronic element on the cable, FIG. 2A to FIG. 2D are the top views corresponding to FIG. 1A to FIG. 1D, and FIG. 3 is the section view for disposing the electronic element on the first circuit. The method for disposing the electronic element on the cable comprises the following steps. As shown in FIG. 1A and FIG. 2A, firstly, a cable 10 is provided. The cable 10 comprises a first circuit 11 and an insulating layer 12. The insulating layer 12 comprises an upper layer and a lower layer and encapsulates the first circuit 11. For clear illustration in FIG. 1A to FIG. 1D, the symbol of the insulating layer 12 is labelled on the upper layer. As shown in FIG. 1B and FIG. 2B, the first circuit 11 and the insulating layer 12 in the cable 10 are cut to form the first hole 13. The first segment 11a and the second segment 11b are formed by cutting the first circuit 11. In an embodiment of the present invention, the insulating layer 12 and the first circuit 11 are cut by various tools such as a cutting tool or a shearing machine and so on. In addition, in an embodiment, the lower insulating layer 12 may be cut or not. As shown in FIG. 1C and FIG. 2C, at the position of the first hole 13, a part of the insulating layer 12 encapsulating the first circuit 11 is removed to form the first opening 141 and the second opening 142. The first opening 141 exposes a part of the first segment 11a of the first circuit 11. The second opening 142 exposes a part of the second segment 11b of the first circuit 11. In an embodiment of the present invention, the method for removing the part of the insulating layer 12 comprises the technologies of burning, melting, and cutting. As shown in FIG. 1D, FIG. 2D, and FIG. 3, the first electronic element E1 is disposed in the first hole 13. The first electronic element E1 has a first pin E1a and a second pin E1b. The first pin E1a is electrically connected to the first segment 11a exposed by the first opening 141. The second pin E1b is electrically connected to the second segment 11b exposed by the second opening 142. In an embodiment of the present invention, the method for disposing the first electronic element E1 on the first segment 11a and on the second segment 11b comprises surface mount technology (SMT). Alternatively, the first pin E1a and the second pin E1b of the first electronic element E1 are fixed on the first segment 11a and on the second segment 11b by adhesive.

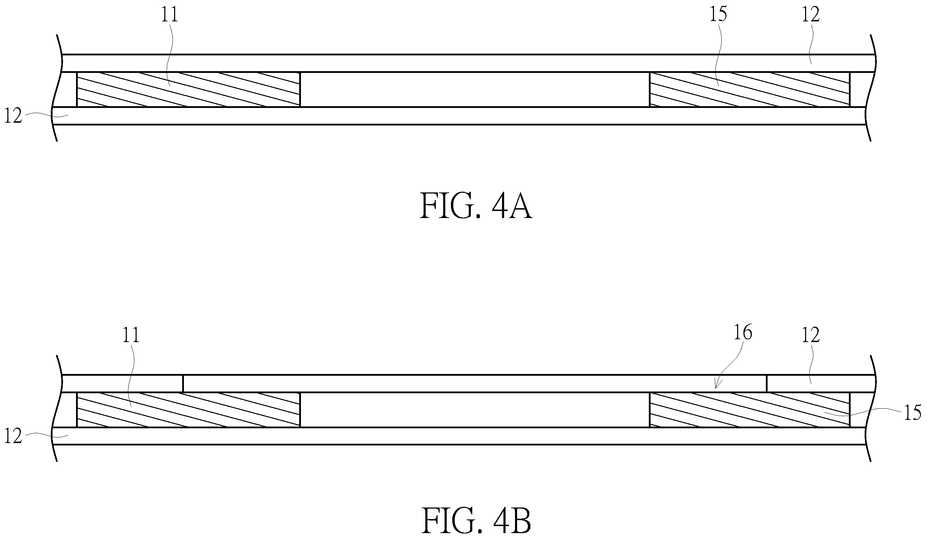

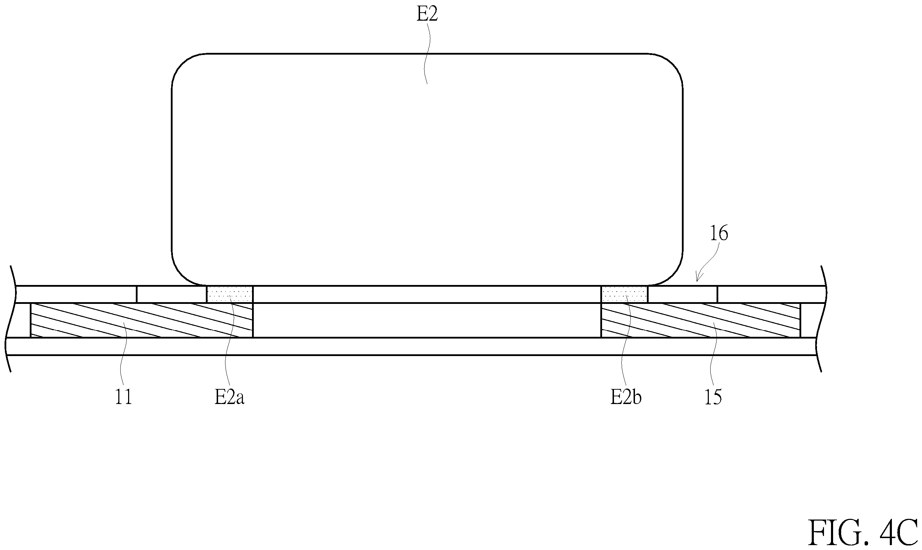

Refer to FIG. 4A to FIG. 4C, which show the second embodiment for disposing the electronic element on the cable. In the above steps, the first electronic element E1 is disposed on two sides of the broken first circuit 11 to connect the pins of the electronic element on the same circuit. Alternatively, since the cable 10 comprises a plurality of parallel circuits, the pins of the electronic element are connected via the plurality of parallel circuits. Furthermore, the cable 10 has a second circuit 15 disposed in parallel with the first circuit 11 and encapsulated by the insulating layer 12. The method for disposing the electronic element on the cable comprises the following steps. As shown in FIG. 4A, the first circuit 11 and the second circuit 15 are disposed in parallel in the cable 10. As shown in FIG. 4B, a part of the insulating layer 12 encapsulating the first circuit 11 and the second circuit 15 are removed at a predetermined position for disposing the electronic element to form a groove 16. As shown in FIG. 4C, the second electronic element E2 is disposed in the groove 16. The second electronic element E2 has a third pin E2a and a fourth pin E2b. The third pin E2a is electrically connected to the first circuit 11 exposed by the groove 16. The fourth pin E2b is electrically connected to the second circuit 15 exposed by the groove 16.

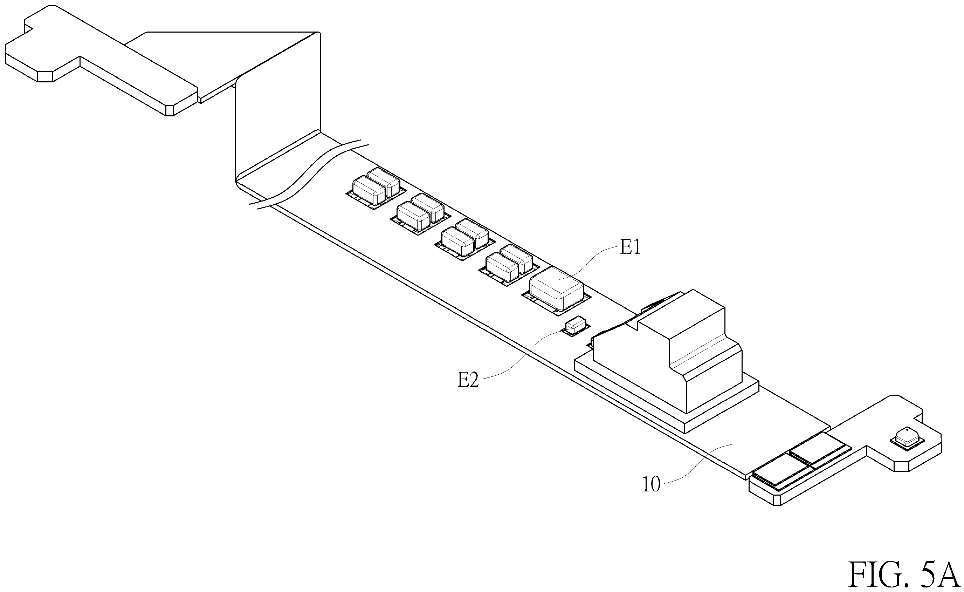

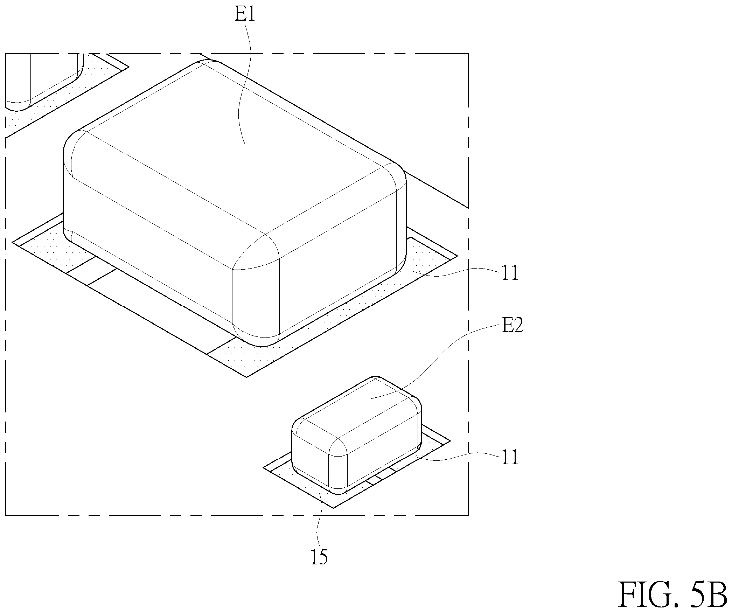

Refer to FIG. 5A and FIG. 5B, which are respectively the stereo diagram and the enlarged schematic diagram of the third embodiment for combining the first and second embodiments. In this embodiment, the aforementioned first method is combined with the aforementioned second method. That is, both the first electronic element E1 and the second electronic element E2 are disposed on the cable 10. The cable 10 has the second circuit 15, and the second circuit 15 is in parallel with the first circuit 11. The second circuit 15 and the first circuit 11 are encapsulated by the insulating layer 12. In the embodiment, the method for disposing the electronic element on the cable comprises the following steps. In step S10, the cable 10 is provided. The cable 10 comprises the first circuit 11 and the insulating layer 12. The insulating layer 12 comprises the upper layer and the lower layer and encapsulates the first circuit 11. In step S11, the first circuit 11 and the insulating layer 12 are cut in the cable 10 to form the first hole 13. The first segment 11a and the second segment 11b are formed by cutting the first circuit 11. In step S12, remove a part of the insulating layer 12 encapsulating the first circuit 11 at the position of the first hole 13 to form the first opening 141 and the second opening 142. The first opening 141 exposes a part of the first segment 11a of the first circuit 11. The second opening 142 exposes a part of the second segment 11b of the first circuit 11. In step S13, the first electronic element E1 is disposed in the first hole 13. The first electronic element E1 has the first pin E1a and the second pin E1b. The first pin E1a is electrically connected to the first segment 11a exposed by the first opening 141. The second pin E1b is electrically connected to the second segment 11b exposed by the second opening 142. In step S14, a part of the insulating layer 12 encapsulating the first circuit 11 and the second circuit 15 is removed at a predetermined position for disposing the electronic element to form the groove 16. In step S15, the second electronic element E2 is disposed in the groove 16. The second electronic element E2 has the third pin E2a and the fourth pin E2b. The third pin E2a is electrically connected to the first circuit 11 exposed by the groove 16. The fourth pin E2b is electrically connected to the second circuit 15 exposed by the groove 16.

Referring to FIG. 1D and FIG. 3 again, in the embodiment as shown on FIG. 1D and FIG. 3, the cable disposing the electronic element comprises the first circuit 11, the insulating layer 12, the first hole 13, the first opening 141, and the second opening 142. The first circuit 11 comprises the first segment 11a and the second segment 11b. The insulating layer 12 encapsulates the first circuit 11. The first hole 13 is disposed between the first segment 11a and the second segment 11b in the insulating layer 12. The first opening 141 is disposed in the first hole 13 and exposes a part of the first segment 11a. The second opening 142 is disposed in the first hole 13 and exposes a part of the second segment 11b. The first electronic element E1 is disposed in the first hole 13. The first electronic element E1 has the first pin E1a and the second pin E1b. The first pin E1a is electrically connected to the first segment 11a exposed by the first opening 141. The second pin E1b is electrically connected to the second segment 11b exposed by the second opening 142.

Referring to FIG. 4C again, in the embodiment of FIG. 4C, the cable disposing the electronic element comprises the first circuit 11, the second circuit 15, the insulating layer 12, and the groove 16. The second circuit 15 is disposed in parallel with the first circuit 11. The insulating layer 12 encapsulates the first circuit 11 and the second circuit 15. The groove 16 is disposed in the insulating layer 12 to expose a part of the first circuit 11 and a part of the second circuit 15. The second electronic element E2 is disposed in the groove 16. The second electronic element E2 has the third pin E2a and the fourth pin E2b. The third pin E2a is electrically connected to the first circuit 11 exposed by the groove 16. The fourth pin E2b is electrically connected to the second circuit 15 exposed by the groove 16.

Referring to FIG. 5A and FIG 5B again, the cable disposing the electronic element comprises the structures of the cable in FIG. 3 and FIG. 4C. In the embodiment, the cable disposing the electronic element comprises the first circuit 11, the insulating layer 12, the first hole 13, the first opening 141, the second opening 142, and the groove 16. The first circuit 11 comprises the first segment 11a and the second segment 11b. The insulating layer 12 encapsulates the first circuit 11 and the second circuit 15. The second circuit 15 is disposed in parallel with the first circuit 11. The first hole 13 is disposed between the first segment 11a and the second segment 11b in the insulating layer 12. The first opening 141 is disposed in the first hole 13 and exposes a part of the first segment 11a. The second opening 142 is disposed in the first hole 13 and exposes a part of the second segment 11b. The first electronic element E1 is disposed in the first hole 13. The first electronic element E1 has the first pin E1a and the second pin E1b. The first pin E1a is electrically connected to the first segment 11a exposed by the first opening 141. The second pin E1b is electrically connected to the second segment 11b exposed by the second opening 142. The groove 16 is disposed in the insulating layer 12, exposing a part of the first circuit 11 and a part of the second circuit 15. The second electronic element E2 is disposed in the groove 16. The second electronic element E2 has the third pin E2a and the fourth pin E2b. The third pin E2a is electrically connected to the first circuit 11 exposed by the groove 16. The fourth pin E2b is electrically connected to the second circuit 15 exposed by the groove 16.

In an embodiment of the present invention, the first electronic element E1 and the second electronic element E2 comprise an SMT element, a pin element such as a resistor, a capacitor, a transistor, an LED, a fuse, and so on. The various first electronic elements E1 are disposed on the first circuit 11 according to the distinct category of the first electronic element E1. Similarly, the various second electronic elements E2 are disposed on the first circuit 11 and the second circuit 15 according to the distinct category of the second electronic element E2. The cable 10 comprises a transmission line such as a material of a flexible flat cable. The flexible flat cable (FFC) comprises an integrated device electronics (IDE) cable and a serial advanced technology attachment (SATA) cable. Accordingly, the distinct electronic elements are widely and elastically disposed on the cable 10 by the method of the present invention.

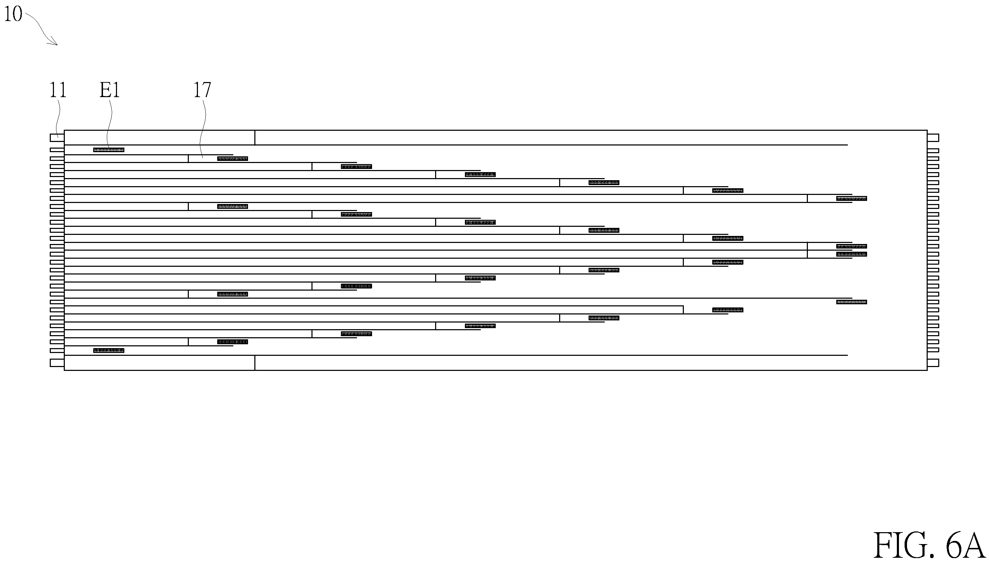

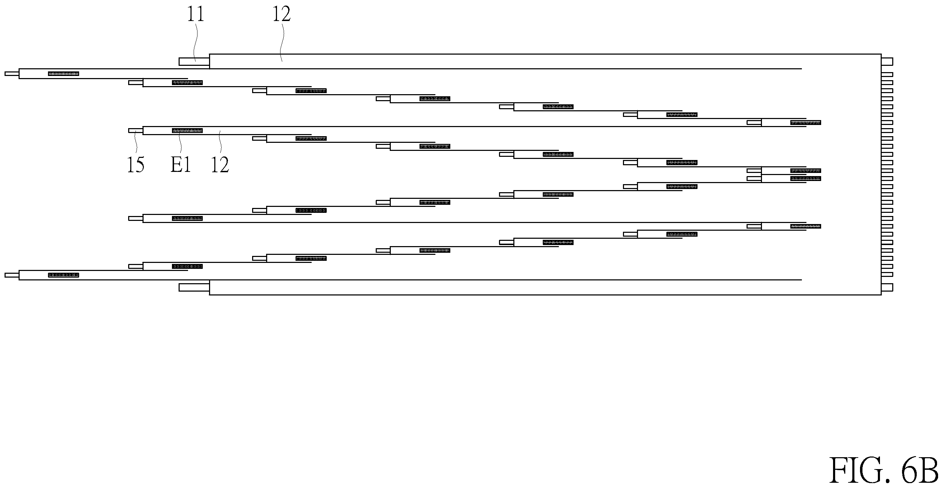

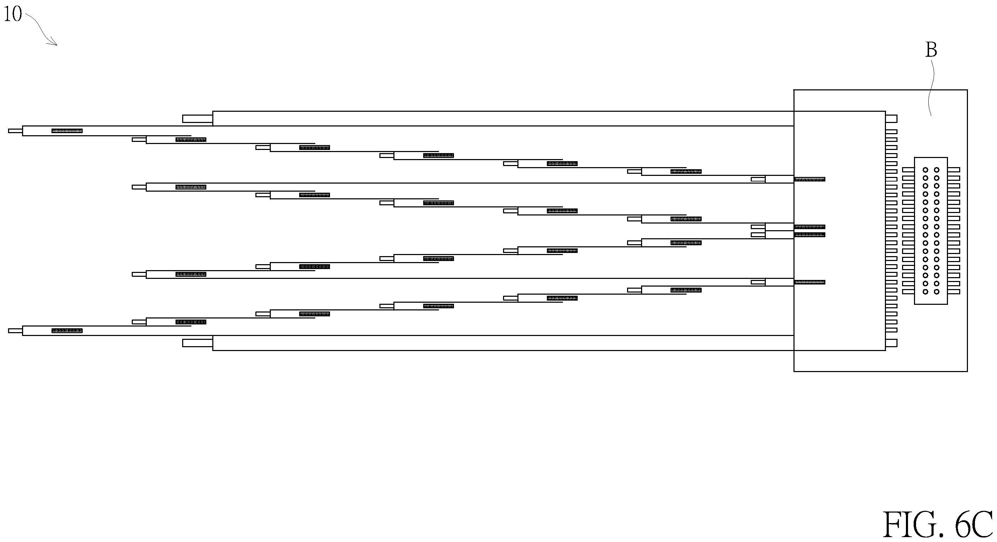

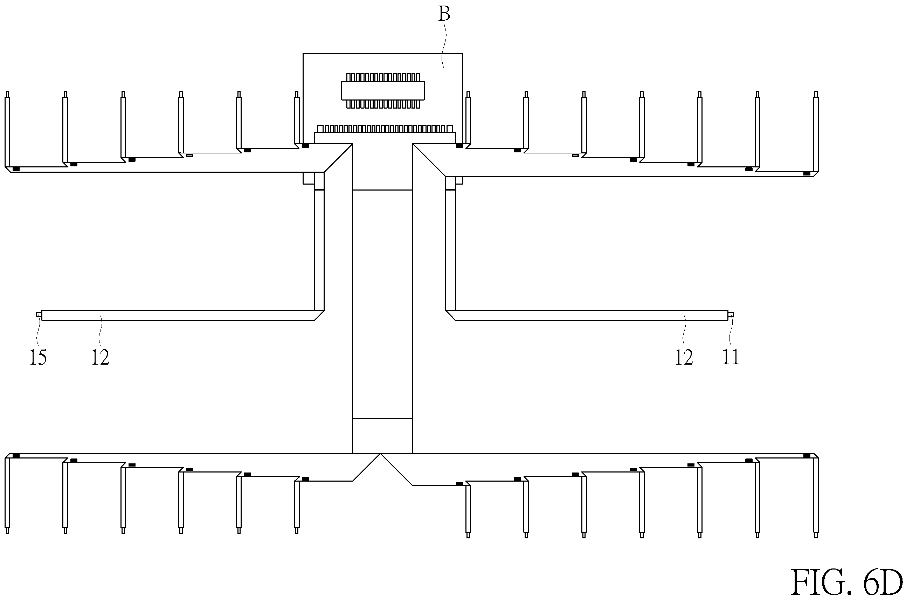

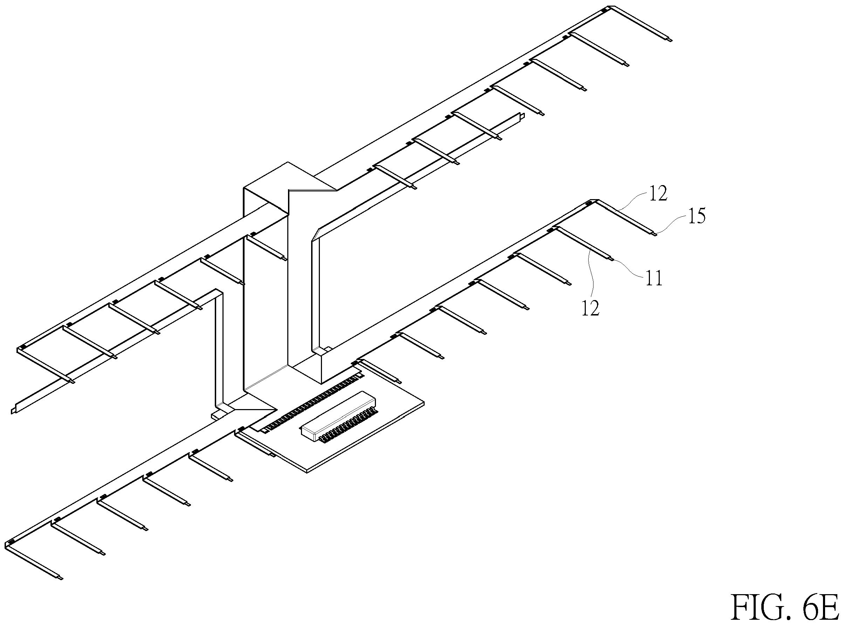

Refer to FIG. 6A to FIG. 6E, which show process flows of folding the circuit of the cable circuit. Being flexible materials, the cable 10, the first circuit 11, and the second circuit 15 are foldable in the space. That is, since the first circuit 11 and the second circuit 15 in the cable are not limited to be disposed on a plane, the cable can be folded to the desired position according to demands. According to FIG. 6A, first of all, the disposed position of the fold line 17 on the insulating layer 12 of the cable is labeled. As shown in FIG. 6B, the redundant first circuit 11, the redundant second circuit 15, and the redundant insulating layer 12 encapsulating the first circuit 11 and the second circuit 15 according to the position of the fold line 17 are removed. As shown in FIG. 6C, an endpoint of the first circuit 11 and an endpoint of the second circuit 15 of the cable 10 are connected to the circuit board B. As shown in FIG. 6D, on a plane, each of the first circuits 11 and each of the second circuits 15 are separately folded towards each predetermined direction and each predetermined angle according to the disposition of each circuit. In an embodiment of the present invention, the predetermined angle may be, but is not limited to, 90 degrees. As shown in FIG. 6E, in a space, each of the first circuits 11 and each of the second circuits 15 are separately folded towards each predetermined direction and each predetermined angle according to the disposition of each circuit to form a three-dimensional structure of the cable 10 with the circuit. It should be noted that the process flows in FIG. 6A to FIG. 6E for folding the circuit of the cable take the embodiment of the first method in FIG. 1A to FIG. 1D as an example. In fact, the process flows in FIG. 6A to FIG. 6E for folding the circuit of the cable can be utilized to the embodiment such as the embodiment of the second method in FIG. 4A to FIG 4C and the embodiment of the first method combined with the second method in FIG. 5A to FIG. 5B.

In summary, since the cable is readily available, the electronic element can be disposed by the method for disposing the electronic element on the cable and the cable thereof in the present invention. Consequently, the electronic element can be disposed and connected in parallel or in series with flexibility, economy, and optimization in the cable. Furthermore, contrary to the flexible printed circuit of the prior art, the manufacture procedures such as drilling, developing, exposing, and etching need to be performed on a flexible circuit board to accomplish the circuit of the circuit board. However, the manufacture procedures will waste more materials and time. In contrast, since the method for disposing the electronic element on the cable of the present invention fits the molded electronic element on a single circuit in the cable, loss of the material is significantly descended. In addition, contrary to the product using the soft material of the cable of the prior art, the product accomplished by the SMT combined with the flexible flat cable of the present invention is capable of enduring a temperature of 260 degrees Celsius in the SMT procedure. That is, the product accomplished by the SMT combined with the flexible flat cable of the present invention has a characteristic of high thermal stability. Hence, the thermal stability of the products can be significantly upgraded and the product can be widely utilized to various electronic elements such as resistors, capacitors, LEDs and so on. Consequently, the products with complexity accomplished by the present invention have diversities. Moreover, for the cable of the prior art, the fuse needs to be disposed in an input/output terminal of the circuit board. In contrast, for the product accomplished by the technology of SMT combined the flexible flat cable, when the fuse as the electronic element is used to be disposed on the circuit of the cable, the fuse is able to be disposed nearby a position of a battery module. Therefore, if the current is overloaded, the fuse is capable of responding in real time and being fused simultaneously. Hence, a safety coefficient of the product can be upgraded.

Even though numerous characteristics and advantages of the present invention have been set forth in the foregoing description, together with details of the structure and features of the invention, the disclosure is illustrative only. Changes may be made in the details, especially in matters of shape, size, and arrangement of parts within the principles of the invention to the full extent indicated by the broad general meaning of the terms in which the appended claims are expressed.

## Claims

1. A cable disposing an electronic element, comprising:
a first circuit, comprising a first segment and a second segment;
an insulating layer, encapsulating the first circuit;
a first hole, disposed between the first segment and the second segment in the insulating layer; and
a first opening, disposed in the first hole and exposing a part of the first segment; and
a second opening, disposed in the first hole and exposing a part of the second segment;
wherein a first electronic element is disposed in the first hole, the first electronic element has a first pin and a second pin, the first pin is electrically connected to the first segment exposed by the first opening, and the second pin is electrically connected to the second segment exposed by the second opening.

2. The cable disposing an electronic element as claimed in claim 1, further comprising:
a second circuit, disposed in parallel with the first circuit and encapsulated by the insulating layer; and
a groove, disposed in the insulating layer and exposing a part of the first circuit and the second circuit;
wherein a second electronic element is disposed in the groove, the second electronic element has a third pin and a fourth pin, the third pin is electrically connected to the first circuit exposed by the groove, and the fourth pin is electrically connected to the second circuit exposed by the groove.

3. The cable disposing an electronic element as claimed in claim 2, wherein the first electronic element and the second electronic element are a fuse.

4. A cable disposing an electronic element, comprising:
a first circuit;
a second circuit, disposed in parallel with the first circuit;
an insulating layer, encapsulating the first circuit and the second circuit; and
a groove, disposed in the insulating layer and exposing a part of the first circuit and a part of the second circuit;
wherein a second electronic element is disposed in the groove, the second electronic element has a third pin and a fourth pin, the third pin is electrically connected to the first circuit exposed by the groove, and the fourth pin is electrically connected to the second circuit exposed by the groove.

5. A method for disposing an electronic element on a cable, comprising the following steps:
providing a cable; wherein the cable has a first circuit and an insulating layer, encapsulating the first circuit;
cutting the first circuit and the insulating layer in the cable to form a first hole; wherein a first segment and a second segment are formed by cutting the first circuit;
removing a part of the insulating layer encapsulating the first circuit at the first hole to form a first opening and a second opening; wherein a part of the first opening exposes the first segment of the first circuit and a part of the second opening exposes the second segment of the first circuit; and
disposing a first electronic element in the first hole; wherein the first electronic element has a first pin and a second pin, the first pin is electrically connected to the first segment exposed by the first opening and the second pin is electrically connected to the second segment exposed by the second opening.

6. The method for disposing the electronic element on the cable as claimed in claim 5, wherein the cable further has a second circuit, the second circuit is in parallel with the first circuit, and the second circuit is encapsulated by the insulating layer;
wherein the method further comprises the following steps:
removing a part of the insulating layer encapsulating the first circuit and a part of the insulating layer encapsulating the second circuit at a predetermined position for disposing the electronic element to form a groove; and
disposing a second electronic element in the groove; wherein the second electronic element has a third pin, electrically connected to the first circuit exposed by the groove and a fourth pin, electrically connected to the second circuit exposed by the groove.

7. The method for disposing the electronic element on the cable as claimed in claim 6, further comprising the following steps:
labelling at least one fold line on the insulating layer of the cable;
removing a part of the first circuit, a part of the second circuit, and the insulating layer encapsulating the first circuit and the second circuit according to a position of the at least one fold line;
connecting an endpoint of the first circuit and an endpoint of the second circuit of the cable to a circuit board;
folding the first circuit and the second circuit according to the position of the at least one fold line with a first predetermined angle and a first predetermined direction on a plane; and
folding the first circuit and the second circuit according to the position of the at least one fold line with a second predetermined angle and a second predetermined direction in a space.

8. A method for disposing an electronic element on a cable, comprising the following steps:
providing a cable, comprising a first circuit, a second circuit, and an insulating layer; wherein the first circuit and the second circuit are disposed in parallel, and are encapsulated by the insulating layer;
removing the insulating layer encapsulating a part of the first circuit and a part of the second circuit at a predetermined position for disposing the electronic element to form a groove; wherein a part of the first circuit and a part of the second circuit are exposed by the groove; and
disposing a second electronic element in the groove; wherein the second electronic element has a third pin and a fourth pin, the third pin is electrically connected to the first circuit exposed by the groove and the fourth pin is electrically connected to the second circuit exposed by the groove.
